(19) Europäisches Patentamt
European Patent Office
Office européen des brevets

(11) **EP 1 700 893 B1**

(12) **EUROPEAN PATENT SPECIFICATION**

(45) Date of publication and mention of the grant of the patent:
**01.10.2008 Bulletin 2008/40**

(51) Int Cl.:
*C09G 1/02* [(2006.01)]     *H01L 21/321* [(2006.01)]

(21) Application number: **06110799.1**

(22) Date of filing: **07.03.2006**

(54) **Chemical mechanical polishing aqueous dispersion, chemical mechanical polishing method, and kit for preparing chemical mechanical polishing aqueous dispersion**

Wässrige Dispersion zum chemisch-mechanischen Polieren, Kit zu deren Herstellung und chemisch-mechanisches Polierverfahren

Suspension aqueuse pour polissage mécano-chimique, procédé de polissage mécano-chimique et kit pour sa préparation

(84) Designated Contracting States:
**DE FR GB IT**

(30) Priority: **09.03.2005 JP 2005064754**

(43) Date of publication of application:
**13.09.2006 Bulletin 2006/37**

(73) Proprietor: **JSR Corporation**
**Tokyo 104-8410 (JP)**

(72) Inventors:
• **Uchikura, Kazuhito, JSR CORPORATION**
**Tokyo 104-8410 (JP)**

• **Hattori, Masayuki**
**498-0026, Aichi-ken (JP)**
• **Kawahashi, Nobuo, JSR CORPORATION**
**Tokyo 104-8410 (JP)**

(74) Representative: **TBK-Patent**
**Bavariaring 4-6**
**80336 München (DE)**

(56) References cited:
EP-A- 1 386 949          WO-A-02/083804
US-A1- 2002 173 241      US-A1- 2003 182 868
US-A1- 2005 037 693

**Description**

BACKGROUND OF THE INVENTION

The present invention relates to a chemical mechanical polishing aqueous dispersion, a chemical mechanical polishing method, and a kit for preparing the chemical mechanical polishing aqueous dispersion.

More particularly, the invention relates to a chemical mechanical polishing aqueous dispersion used in the manufacture of semiconductor devices capable of efficiently chemically and mechanically polishing each polishing target material provided on a semiconductor substrate and forming a sufficiently planarized accurate finished surface, a chemical mechanical polishing method using the chemical mechanical polishing aqueous dispersion, and a kit for preparing the chemical mechanical polishing aqueous dispersion.

In recent years, along with an increase in the degree of integration of semiconductor devices, scaling down of interconnects formed in a semiconductor device has progressed. A damascene method is known as a technology capable of achieving scaling down of interconnects. In the damascene method, a groove formed in an insulating material is filled with an interconnect material, and unnecessary interconnect material deposited in the area other than the groove is removed by chemical mechanical polishing to form a desired interconnect. When using copper or a copper alloy as the interconnect material, a barrier metal film is generally formed of tantalum, tantalum nitride, titanium nitride, or the like at the interface between copper or a copper alloy and the insulating material in order to prevent migration of a copper atom into the insulating material.

When using the damascene method in the manufacture of semiconductor devices using copper or a copper alloy as the interconnect material, chemical mechanical polishing is performed in various ways. As the chemical mechanical polishing method, two-stage chemical mechanical polishing is advantageously performed which includes a first polishing step of mainly removing copper or a copper alloy and a second polishing step of mainly removing the barrier metal film.

In the second polishing step, the insulating film exposed after removing the barrier metal is polished to a small extent in addition to removing the barrier metal in the area other than the interconnect area in order to obtain a highly planarized polished surface by repairing recess-shaped surface defects such as dishing or erosion considerably occurring in the interconnect area in the first polishing step. In the interconnect area, the insulating film, copper or a copper alloy used as the interconnect material, and the barrier metal formed between the interconnect material and the insulating film are chemically and mechanically polished.

In order to obtain a sufficiently planarized accurate finished surface, it is desirable that a chemical mechanical polishing aqueous dispersion used in the second polishing step remove copper or a copper alloy, the barrier metal, and the insulating film at an equal rate.

In order to achieve this object, JP-A-2001-196336 discloses a chemical mechanical polishing aqueous dispersion containing abrasives, an oxidizing agent, and a specific polishing rate adjusting agent. An example of the patent document 1 discloses two-stage polishing using a chemical mechanical polishing aqueous dispersion having a ratio "$R_{Cu}/R_{BM}$" of the polishing rate $R_{Cu}$ of the copper film to the polishing rate $R_{BM}$ of the barrier metal film of 0.66 to 1.11 and a ratio "$R_{Cu}/R_{In}$" of the polishing rate $R_{Cu}$ of the copper film to the polishing rate $R_{In}$ of the insulating film of 0.72 to 1.42 in the second polishing step.

In most cases, the polishing time of the second polishing step is individually determined depending on the type, conditions, etc. of the polishing target. In recent years, from the viewpoint of a demand for uniform process management and the process stability of the second polishing step, a chemical mechanical polishing aqueous dispersion has been demanded which ensures that an accurate finished surface can be obtained by performing the second polishing step for a predetermined polishing time. Specifically, a chemical mechanical polishing aqueous dispersion has been in demand which prevents the progression of dishing or erosion in the interconnect area even if chemical mechanical polishing is performed for a period of time greater than the optimum polishing time individually set for the polishing target.

Known chemical mechanical polishing aqueous dispersions have not been examined from such a viewpoint.

SUMMARY

The invention may provide a chemical mechanical polishing aqueous dispersion which can efficiently polish each polishing target layer, produce a sufficiently planarized accurate finished surface, and prevent the progression of dishing or erosion in the interconnect area even if chemical mechanical polishing is performed for a period of time greater than the optimum polishing time, a chemical mechanical polishing method using the chemical mechanical polishing aqueous dispersion, and a kit for preparing the chemical mechanical polishing aqueous dispersion.

According to a first aspect of the invention, there is provided a chemical mechanical polishing aqueous dispersion according to claim 1.

In this chemical mechanical polishing aqueous dispersion, the abrasives (A) may include at least one type of abrasive selected from the group consisting of inorganic particles, organic particles, and organic-inorganic composite particles. In this case, the abrasives (A) may have an average particle diameter of 5 to 1000 nm.

In this chemical mechanical polishing aqueous dispersion, the inorganic particle may be silica.

In this chemical mechanical polishing aqueous dispersion, the organic acid (B) may be at least one organic acid selected from the group consisting of quinolinecarboxylic acid, quinolinic acid, maleic acid, malonic acid, citric acid, and malic acid, and be included in the chemical mechanical polishing aqueous dispersion in an amount of 0.05 to 2 wt%.

In this chemical mechanical polishing aqueous dispersion, the benzotriazole or benzotriazole derivative (C) may be benzotriazole, and be included in the chemical mechanical polishing aqueous dispersion in an amount of 0.01 to 5 wt%.

In this chemical mechanical polishing aqueous dispersion, the poly(meth)acrylate (D) may have an average molecular weight of 1,000 to 100,000. In this case, the poly(meth)acrylate (D) may be an ammonium salt of polyacrylic acid, and may be included in the chemical mechanical polishing aqueous dispersion in an amount of 0.01 to 2 wt%.

In this chemical mechanical polishing aqueous dispersion, the oxidizing agent (E) may be hydrogen peroxide, and be included in the chemical mechanical polishing aqueous dispersion in an amount of 0.01 to 5 wt%.

The chemical mechanical polishing aqueous dispersion may have a pH of 2.0 to 4.0.

According to a second aspect of the invention, there is provided a kit for preparing the above-described chemical mechanical polishing aqueous dispersion by mixing a liquid (I) and a liquid (II), the liquid (I) being an aqueous dispersion including the abrasives (A), the organic acid (B), the benzotriazole or benzotriazole derivative (C), the poly(meth)acrylate (D), and the water (F), the abrasives (A) being contained in the aqueous dispersion in an amount of 2 to 10 wt%, and the liquid (II) including the oxidizing agent (E) and the water (F).

According to a third aspect of the invention, there is provided a kit for preparing the above-described chemical mechanical polishing aqueous dispersion by mixing a liquid (I) and a liquid (II), the liquid (I) being an aqueous dispersion including the abrasives (A) and the water (F), and the liquid (II) including the organic acid (B) and the water (F).

According to a fourth aspect of the invention, there is provided a kit for preparing the above-described chemical mechanical polishing aqueous dispersion by mixing a liquid (I), a liquid (II), and a liquid (III), the liquid (I) being an aqueous dispersion including the abrasives (A) and the water (F), the liquid (II) including the organic acid (B) and the water (F), and the liquid (III) including the oxidizing agent (E) and the water (F).

In this kit for preparing the chemical mechanical polishing aqueous dispersion, the liquid (I) may further include at least one component selected from the organic acid (B), the benzotriazole or benzotriazole derivative (C), the poly (meth)acrylate (D), and the oxidizing agent (E).

In this kit for preparing the chemical mechanical polishing aqueous dispersion, the liquid (II) may further include at least one component selected from the abrasives (A), the benzotriazole or benzotriazole derivative (C), the poly(meth) acrylate (D), and the oxidizing agent (E).

According to a fifth aspect of the invention, there is provided a chemical mechanical polishing method, comprising:

chemically and mechanically polishing a polishing target using a chemical mechanical polishing aqueous dispersion having, when chemically and mechanically polishing each of a copper film, a barrier metal film, and an insulating film under identical conditions, a ratio "$R_{Cu}/R_{BM}$" of a polishing rate $R_{Cu}$ of the copper film to a polishing rate $R_{BM}$ of the barrier metal film of 50 or more and a ratio "$R_{Cu}/R_{In}$" of the polishing rate $R_{Cu}$ of the copper film to a polishing rate $R_{In}$ of the insulating film of 50 or more, and then chemically and mechanically polishing the polishing target using the above-described chemical mechanical polishing aqueous dispersion.

The above-described chemical mechanical polishing aqueous dispersion, chemical mechanical polishing method using the chemical mechanical polishing aqueous dispersion, and kit for preparing the chemical mechanical polishing aqueous dispersion enable to efficiently polish each polishing target layer, produce a sufficiently planarized accurate finished surface, and prevent the progression of dishing or erosion in the interconnect area even if chemical mechanical polishing is performed for a period of time greater than the optimum polishing time.

BRIEF DESCRIPTION OF THE SEVERAL VIEWS OF THE DRAWING

FIGS. 1A to 1C are schematic views showing an example of a polishing target surface of a chemical mechanical polishing method according to a second embodiment of the invention.
FIGS. 2A to 2C are schematic views showing another example of the polishing target surface of the chemical mechanical polishing method according to the second embodiment of the invention.

DETAILED DESCRIPTION OF THE EMBODIMENT

1. Chemical Mechanical Polishing Aqueous Dispersion

A chemical mechanical polishing aqueous dispersion according to a first embodiment of the invention includes (A) abrasives, (B) an organic acid, (C) benzotriazole or a benzotriazole derivative, (D) a poly(meth)acrylate, (E) an oxidizing agent, and (F) water, the abrasives (A) being included in the chemical mechanical polishing aqueous dispersion in an amount of 2 to 10 wt%.

1.1. Abrasives (A)

The abrasives (A) may be at least one type of abrasive selected from the group consisting of inorganic particles, organic particles, and organic-inorganic composite particles.
As examples of the inorganic particles, silica, alumina, titania, zirconia, ceria, and the like can be given. As examples of the silica, fumed silica, silica synthesized by a sol-gel method, and the like can be given. The fumed silica may be obtained by reacting silicon chloride or the like with oxygen and water in a gaseous phase. The silica synthesized by the sol-gel method may be obtained by hydrolysis and/or condensation of an alkoxysilicon compound as the raw material. Colloidal silica may be obtained by an inorganic colloid method using a raw material purified in advance, for example.
As examples of the organic particles, polyvinyl chloride, styrene (co)polymer, polyacetal, polyester, polyamide, polycarbonate, olefin (co)polymer, phenoxy resin, acrylic (co)polymer, and the like can be given. As examples of the olefin (co)polymer, polyethylene, polypropylene, poly-1-butene, poly-4-methyl-1-pentene, and the like can be given. As examples of the acrylic (co)polymer, polymethyl methacrylate and the like can be given.
The type and the configuration of the organic-inorganic composite particles are not particularly limited insofar as inorganic particles and organic particles as mentioned above are integrally formed in such a manner that the inorganic particles and the organic particles are not easily separated during the chemical mechanical polishing step.
The organic-inorganic composite particles may have one of the following configurations (i) to (iii).

(i) Organic-inorganic composite particles obtained by polycondensation of an alkoxide compound of a metal or silicon in the presence of organic particles. As examples of the alkoxide compound of a metal or silicon, an alkoxysilane, aluminum alkoxide, titanium alkoxide, and the like can be given. The resulting polycondensate may be bonded to a functional group of the organic particle either directly or through an appropriate coupling agent (e.g. silane coupling agent).
(ii) Organic-inorganic composite particles in which organic particles and inorganic particles having zeta potentials of opposite polarities (positive or negative) are bonded by an electrostatic force. In this case, the composite particles may be formed by mixing the organic particles and the inorganic particles in a pH region in which the organic particles and the inorganic particles have zeta potentials of opposite polarities, or may be formed by mixing the organic particles and the inorganic particles in a pH region in which the organic particles and the inorganic particles have zeta potentials of an identical polarity and changing the solution properties to a pH region in which the organic particles and the inorganic particles have zeta potentials of opposite polarities.
(iii) Organic-inorganic composite particles obtained by polycondensation of an alkoxide compound of a metal or silicon in the presence of the composite particles (ii). As the alkoxide compound of a metal or silicon, the alkoxide compound given for the organic-inorganic composite particles (i) may be used.

It is preferable that the abrasives (A) included in the chemical mechanical polishing aqueous dispersion according to the first embodiment be at least one type of abrasive selected from the group consisting of the silica, the organic particles, and the organic-inorganic composite particles mentioned above.
The impurity metal content in the abrasives (A) is preferably 10 ppm or less, more preferably 5 ppm or less, still more preferably 3 ppm or less, and most preferably 1 ppm or less of the abrasives (A). As examples of the impurity metal, iron, nickel, zinc, and the like can be given.
The average particle diameter of the abrasives (A) is preferably 5 to 1,000 nm, more preferably 7 to 700 nm, and still more preferably 10 to 500 nm. The balance between the polishing rate and an excellent polished surface can be achieved by using the abrasives having an average particle diameter in this range.
The amount of the abrasives (A) included in the chemical mechanical polishing aqueous dispersion according to the first embodiment is 2 to 10 wt%, and preferably 2 to 5 wt% of the total amount of the chemical mechanical polishing aqueous dispersion.

1.2. Organic acid (B)

As the organic acid (B) included in the chemical mechanical polishing aqueous dispersion according to the first embodiment, an organic acid having four or more carbon atoms is preferable. As the organic acid having four or more carbon atoms, an aliphatic organic acid having four or more carbon atoms and an organic acid having a heterocyclic ring are preferable.

As the aliphatic organic acid having four or more carbon atoms, an aliphatic polycarboxylic acid having four or more carbon atoms, a hydroxyl acid having four or more carbon atoms, and the like are preferable. As specific examples of the aliphatic polycarboxylic acid having four or more carbon atoms, divalent organic acids such as maleic acid, succinic acid, fumaric acid, glutaric acid, and adipic acid can be given. As specific examples of the hydroxyl acid having four or more carbon atoms, citric acid, malic acid, tartaric acid, and the like can be given. As examples of the organic acid having a heterocyclic ring, quinolinecarboxylic acid, pyridinecarboxylic acid, pyridinedicarboxylic acid, pyrazinecarboxylic acid, and the like can be given. Of these, quinaldic acid (e.g. 2-quinolinecarboxylic acid), quinolinic acid (e.g. 2,3-pyridinedicarboxylic acid), divalent organic acid (e.g. maleic acid or citric acid), and hydroxyl acid (e.g. malic acid or malonic acid) are preferable, with quinaldic acid and quinolinic acid being still more preferable.

The amount of the organic acid (B) included in the chemical mechanical polishing aqueous dispersion according to the first embodiment is 0.01 to 5 wt%, and preferably 0.05 to 2 wt% of the total amount of the chemical mechanical polishing aqueous dispersion. The balance between the polishing rate and an excellent polished surface can be achieved by adjusting the amount of the organic acid (B) in this range.

The balance between the polishing rate and an excellent polished surface can be more advantageously achieved by using at least one organic acid selected from the group consisting of quinolinecarboxylic acid, quinolinic acid, divalent organic acid (excluding quinolinic acid), and hydroxyl acid as the organic acid (B) in an amount of 0.01 to 5 wt%, for example. In this case, the balance between the polishing rate and an excellent polished surface can be further advantageously achieved by using at least one organic acid selected from the group consisting of quinolinecarboxylic acid, quinolinic acid, maleic acid, malonic acid, citric acid, and malic acid as the organic acid (B) in an amount of 0.05 to 2 wt%.

1.3. Benzotriazole or benzotriazole derivative (C)

The chemical mechanical polishing aqueous dispersion according to the first embodiment includes the benzotriazole or benzotriazole derivative (C).

The benzotriazole derivative used herein refers to a compound obtained by replacing at least one hydrogen atom of benzotriazole with a functional group such as a carboxyl group, methyl group, amino group, or hydroxyl group.

As the benzotriazole or benzotriazole derivative (C), benzotriazole, methylbenzotriazole, 4-carboxybenzotriazole and its salt, 7-carboxybenzotriazole and its salt, benzotriazole butyl ester, 1-hydroxymethylbenzotriazole, 1-hydroxybenzotriazole, 1-(2,3-dihydroxypropyl)benzotriazole, 1-(2-hydroxyethyl)benzotriazole, 2-(benzotriazyl)ethanesulfonic acid and its salt, 1-(2-ethylhexylaminomethyl)benzotriazole, and the like are preferable. Of these, benzotriazole, methylbenzotriazole, 4-carboxybenzotriazole and its salt, 7-carboxybenzotriazole and its salt, benzotriazole butyl ester, 1-hydroxymethylbenzotriazole, and 1-hydroxybenzotriazole are still more preferable, with benzotriazole being most preferable.

The amount of the benzotriazole or benzotriazole derivative (C) included in the chemical mechanical polishing aqueous dispersion according to the first embodiment is 0.01 to 5 wt%, and preferably 0.05 to 2 wt% of the total amount of the chemical mechanical polishing aqueous dispersion. The balance between the polishing rate and an excellent polished surface can be achieved by adjusting the amount of the benzotriazole or benzotriazole derivative (C) in this range.

The balance between the polishing rate and an excellent polished surface can be more advantageously achieved by using benzotriazole as the benzotriazole or benzotriazole derivative (C) in an amount of 0.01 to 5 wt%, for example.

1.4. Poly(meth)acrylate (D)

The chemical mechanical polishing aqueous dispersion according to the first embodiment includes the poly(meth)acrylate (D). As the counter cation in the poly(meth)acrylate, an ammonium ion, alkylammonium ion, potassium ion, and the like can be given.

The polystyrene-reduced number average molecular weight of the poly(meth)acrylate (D) determined by gel permeation chromatography using water as the eluent is preferably 1,000 to 100,000, and still more preferably 5,000 to 70,000. A chemical mechanical polishing aqueous dispersion exhibiting an excellent process margin (the process margin used herein refers to the performance of the aqueous dispersion by which the surface state of the polishing target surface does not deteriorate even if chemical mechanical polishing is performed for a period of time greater than the optimum polishing time) can be obtained by using the poly(meth)acrylate (D) having a number average molecular weight in this range.

The amount of the poly(meth)acrylate (D) included in the chemical mechanical polishing aqueous dispersion according to the first embodiment is 0.001 to 5 wt%, and preferably 0.01 to 2 wt% of the total amount of the chemical mechanical polishing aqueous dispersion. A chemical mechanical polishing aqueous dispersion exhibiting an excellent process margin can be obtained by adjusting the amount of the poly(meth)acrylate (D) in this range.

An excellent process margin can be reliably achieved by using the poly(meth)acrylate (D) having an average molecular weight of 1,000 to 100,000 in an amount of 0.001 to 5 wt%, for example. In this case, an excellent process margin can be more reliably achieved by using an ammonium salt of polyacrylic acid as the poly(meth)acrylate (D) in an amount of 0.01 to 2 wt%.

1.5. Oxidizing agent (E)

As examples of the oxidizing agent (E) included in the chemical mechanical polishing aqueous dispersion according to the first embodiment, a persulfate, hydrogen peroxide, inorganic acid, organic peroxide, polyvalent metal salt, and the like can be given. As examples of the persulfate, ammonium persulfate, potassium persulfate, and the like can be given. As examples of the inorganic acid, nitric acid, sulfuric acid, and the like can be given. As examples of the organic peroxide, peracetic acid, perbenzoic acid, tert-butyl hydroperoxide, and the like can be given.

As examples of the polyvalent metal salt, a permanganic acid compound, dichromic acid compound, and the like can be given. As examples of the permanganic acid compound, potassium permanganate and the like can be given. As examples of the dichromic acid compound, potassium dichromate and the like can be given.

Of these, hydrogen peroxide, persulfate, and inorganic acid are preferable, with hydrogen peroxide being particularly preferable.

The amount of the oxidizing agent (E) is preferably 0.01 to 5 wt%, and still more preferably 0.05 to 2 wt% of the total amount of the aqueous dispersion. The balance between the polishing rate and an excellent polished surface can be achieved by adjusting the amount of the oxidizing agent (E) in this range.

The balance between the polishing rate and an excellent polished surface can be more reliably achieved by using hydrogen peroxide as the oxidizing agent (E) in an amount of 0.01 to 5 wt%, for example.

When using hydrogen peroxide as the oxidizing agent (E) in the chemical mechanical polishing aqueous dispersion according to the first embodiment, an appropriate polyvalent metal ion having a function of promoting the function of hydrogen peroxide as the oxidizing agent and a function of improving the polishing rate may be added to the chemical mechanical polishing aqueous dispersion.

1.6. Water (F)

In the chemical mechanical polishing aqueous dispersion according to the first embodiment, it is preferable to use the water (F) as the aqueous medium. A mixed medium of the water (F) and an organic solvent miscible with water (e.g. alcohol or alkylene glycol derivative) may be used as the aqueous medium. It is preferable to use a mixed medium of water and methanol or the like.

1.7. Other components

The chemical mechanical polishing aqueous dispersion according to the first embodiment may arbitrarily include a surfactant, a pH adjusting agent, and the like in addition to the above-described components.

As examples of the surfactant, a cationic surfactant, anionic surfactant, ampholytic surfactant, nonionic surfactant, and the like can be given. It is preferable to use the anionic surfactant or the nonionic surfactant.

As examples of the anionic surfactant, a carboxylate, sulfonate, sulfate salt, phosphate salt, and the like can be given. As examples of the carboxylate, fatty acid soap, alkyl ether carboxylate, and the like can be given. As examples of the sulfonate, alkylbenzenesulfonate, alkylnaphthalenesulfonate, alpha-olefin sulfonate, and the like can be given. As examples of the sulfate salt, a higher alcohol sulfate salt, alkyl ether sulfate, polyoxyethylene alkyl phenyl ether sulfate, and the like can be given. As examples of the phosphate salt, an alkyl phosphate salt and the like can be given. It is preferable to use the sulfonate. It is still more preferable to use the alkylbenzenesulfonate, with potassium dodecylbenzenesulfonate being particularly preferable.

As examples of the nonionic surfactant, a polyethylene glycol type surfactant, acetylene glycol, ethylene oxide addition product of acetylene glycol, acetylene alcohol, and the like can be given.

As examples of the PH adjusting agent, an organic base, inorganic base, and inorganic acid can be given.

As examples of the organic base, tetramethylammonium hydroxide, triethylamine, and the like can be given.

As examples of the inorganic base, ammonia, potassium hydroxide, and the like can be given.

As examples of the inorganic acid, nitric acid, sulfuric acid, and the like can be given.

The pH of the chemical mechanical polishing aqueous dispersion according to the first embodiment is preferably 1.0 to 5.0, more preferably 1.5 to 4.5, and more preferably 2.0 to 4.0. The balance between the polishing rate and an excellent polished surface can be achieved by adjusting the pH of the chemical mechanical polishing aqueous dispersion in this range.

1.8. Kit for preparing chemical mechanical polishing aqueous dispersion

The chemical mechanical polishing aqueous dispersion according to the first embodiment may be supplied in a state in which the prepared chemical mechanical polishing aqueous dispersion can be directly used as a polishing composition. Or, a polishing composition containing each component of the chemical mechanical polishing aqueous dispersion according to the first embodiment at a high concentration (i.e. concentrated polishing composition) may be provided, and the concentrated polishing composition may be diluted before use to obtain a desired chemical mechanical polishing aqueous dispersion.

For example, the chemical mechanical polishing aqueous dispersion according to the first embodiment may be separately provided as two or more liquids (e.g. two or three liquids), and the liquids may be mixed before use. The chemical mechanical polishing aqueous dispersion according to the first embodiment may be prepared by mixing two or more liquids using first to third kits described below, for example.

1.8.1. First kit

The first kit is a kit for preparing the chemical mechanical polishing aqueous dispersion according to the first embodiment by mixing a liquid (I) and a liquid (II). In the first kit, the liquid (I) includes the abrasives (A), the organic acid (B), the benzotriazole or benzotriazole derivative (C), the poly(meth)acrylate (D), and the water (F), the liquid (I) containing the abrasives (A) in an amount of 2 to 10 wt%, and the liquid (II) includes the oxidizing agent (E) and the water (F).

When preparing the liquid (I) and the liquid (II) of the first kit, it is necessary to determine the concentration of each component in the liquid (I) and the liquid (II) so that each component is included in the aqueous dispersion obtained by mixing the liquid (I) and the liquid (II) in the above-mentioned concentration range. Each of the liquid (I) and the liquid (II) may include each component at a high concentration (i.e. may be concentrated). In this case, the liquid (I) and the liquid (II) may be diluted before use. According to the first kit, the storage stability of the oxidizing agent can be improved by separately providing the liquid (I) and the liquid (II).

When preparing the chemical mechanical polishing aqueous dispersion according to the first embodiment using the first kit, it suffices that the liquid (I) and the liquid (II) be separately provided and supplied and be integrally mixed at the time of polishing. The mixing method and the mixing timing are not particularly limited.

For example, the liquid (I) and the liquid (II) may be separately supplied to a polishing system and mixed on a platen. Or, the liquid (I) and the liquid (II) may be mixed before being supplied to the polishing system, or may be mixed in the polishing system when supplied through a line, or may be mixed in a mixing tank additionally provided. A line mixer or the like may be used to obtain a more uniform aqueous dispersion.

1.8.2. Second kit

The second kit is a kit for preparing the chemical mechanical polishing aqueous dispersion according to the first embodiment by mixing a liquid (I) and a liquid (II). In the second kit, the liquid (I) is an aqueous dispersion including the abrasives (A) and the water (F), and the liquid (II) includes the organic acid (B) and the water (F).

When preparing the liquid (I) and the liquid (II) of the second kit, it is necessary to determine the concentration of each component in the liquid (I) and the liquid (II) so that each component is included in the aqueous dispersion obtained by mixing the liquid (I) and the liquid (II) in the above-mentioned concentration range. Each of the liquid (I) and the liquid (II) may include each component at a high concentration (i.e. may be concentrated). In this case, the liquid (I) and the liquid (II) may be diluted before use. According to the second kit, the storage stability of the aqueous dispersion can be improved by separately providing the liquid (I) and the liquid (II).

When preparing the chemical mechanical polishing aqueous dispersion according to the first embodiment using the second kit, it suffices that the liquid (I) and the liquid (II) be separately provided and supplied and be integrally mixed at the time of polishing. The mixing method and the mixing time are not particularly limited.

For example, the liquid (I) and the liquid (II) may be separately supplied to a polishing system and mixed on a platen. Or, the liquid (I) and the liquid (II) may be mixed before being supplied to the polishing system, or may be mixed in the polishing system when supplied through a line, or may be mixed in a mixing tank additionally provided. A line mixer or the like may be used to obtain a more uniform aqueous dispersion.

1.8.3. Third kit

The third kit is a kit for preparing the chemical mechanical polishing aqueous dispersion according to the first embodiment by mixing a liquid (I), a liquid (II), and a liquid (III). In the third kit, the liquid (I) is an aqueous dispersion including the abrasives (A) and the water (F), the liquid (II) includes the organic acid (B) and the water (F), and the liquid (III) includes the oxidizing agent (E) and the water (F).

When preparing the liquid (I), the liquid (II), and the liquid (III) of the third kit, it is necessary to determine the concentration of each component in the liquid (I), the liquid (II), and the liquid (III) so that each component is included in the aqueous dispersion obtained by mixing the liquid (I), the liquid (II), and the liquid (III) in the above-mentioned concentration range. Each of the liquid (I), the liquid (II), and the liquid (III) may include each component at a high concentration (i.e. may be concentrated). In this case, the liquid (I), the liquid (II), and the liquid (III) may be diluted before use. According to the third kit, the storage stability of the aqueous dispersion can be improved by separately providing the liquid (I), the liquid (II), and the liquid (III).

When preparing the chemical mechanical polishing aqueous dispersion according to the first embodiment using the third kit, it suffices that the liquid (I), the liquid (II), and the liquid (III) be separately provided and supplied and be integrally mixed at the time of polishing. The mixing method and the mixing time are not particularly limited.

For example, the liquid (I), the liquid (II), and the liquid (III) may be separately supplied to a polishing system and mixed on a platen. Or, the liquid (I), the liquid (II), and the liquid (III) may be mixed before being supplied to the polishing system, or may be mixed in the polishing system when supplied through a line, or may be mixed in a mixing tank additionally provided. A line mixer or the like may be used to obtain a more uniform aqueous dispersion.

In the second and third kits, the liquid (I) may further include at least one component selected from the organic acid (B), the benzotriazole or benzotriazole derivative (C), the poly(meth)acrylate (D), and the oxidizing agent (E), and the liquid (II) may further include at least one component selected from the abrasives (A), the benzotriazole or benzotriazole derivative (C), the poly(meth)acrylate (D), and the oxidizing agent (E).

The chemical mechanical polishing aqueous dispersion according to the first embodiment may be suitably used as a chemical mechanical polishing aqueous dispersion in a second polishing step in two-stage polishing for forming a copper damascene interconnect, for example. In particular, when using a specific chemical mechanical polishing aqueous dispersion described later as a chemical mechanical polishing aqueous dispersion in the first polishing step, the chemical mechanical polishing aqueous dispersion according to the first embodiment exhibits more excellent polishing properties by using the chemical mechanical polishing aqueous dispersion as the chemical mechanical polishing aqueous dispersion in the second polishing step.

2. Chemical Mechanical Polishing Method

A chemical mechanical polishing method according to a second embodiment of the invention includes chemically and mechanically polishing a polishing target using the chemical mechanical polishing aqueous dispersion according to the first embodiment of the invention. The chemical mechanical polishing method according to the second embodiment includes chemically and mechanically polishing a polishing target using a chemical mechanical polishing aqueous dispersion (hereinafter may be called "first polishing aqueous dispersion") having, when chemically and mechanically polishing each of a copper film, a barrier metal film, and an insulating film under identical conditions, a ratio "$R_{Cu}/R_{BM}$" of a polishing rate $R_{Cu}$ of the copper film to a polishing rate $R_{BM}$ of the barrier metal film of 50 or more and a ratio "$R_{Cu}/R_{In}$" of the polishing rate $R_{Cu}$ of the copper film to a polishing rate $R_{In}$ of the insulating film of 50 or more (hereinafter may be called "first polishing step"), and chemically and mechanically polishing the polishing target using the chemical mechanical polishing aqueous dispersion according to the first embodiment ("second polishing step").

In the chemical mechanical polishing method according to the second embodiment, the first polishing step and the second polishing step may be continuously performed in a state in which the polishing target is installed in a polishing system by sequentially changing the polishing aqueous dispersion supplied. Or, the polishing target may be removed from a polishing system after the first polishing step, the removed polishing target may be installed in the same polishing system after changing the polishing aqueous dispersion supplied, and then the second polishing step may be performed.

The first polishing step and the second polishing step may be performed using different polishing systems.

When using a polishing system provided with two or more polishing pads, the first polishing step and the second polishing step may be performed using different polishing pads, or a single polishing pad may be used in the first polishing step and the second polishing step.

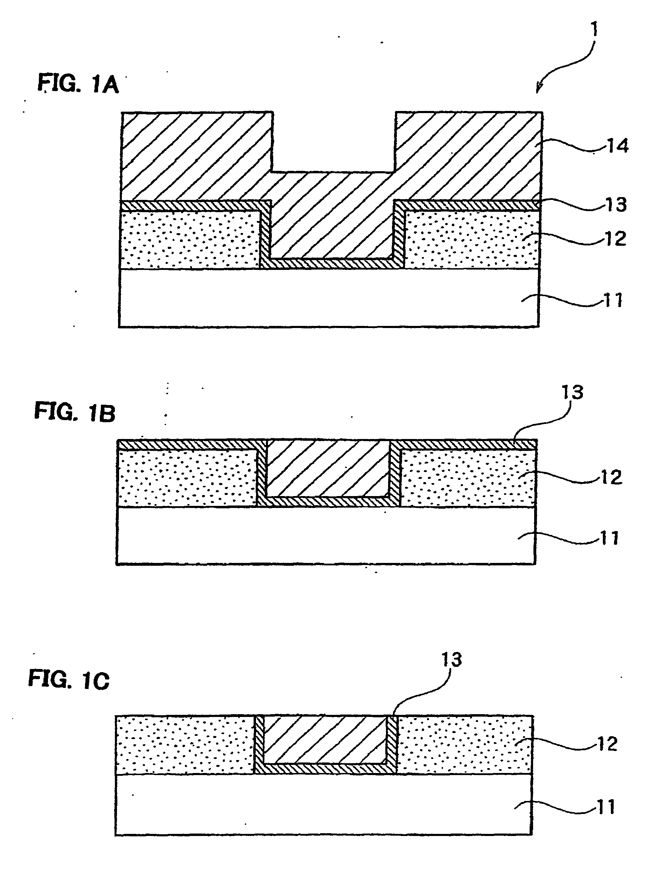

As an example of the polishing target of the chemical mechanical polishing method according to the second embodiment, a composite substrate material 1 having a structure as shown in FIG. 1A can be given. The composite substrate material 1 includes a substrate 11 formed of silicon or the like, an insulating film 12 formed by a PETEOS film (film formed by a CVD method using tetraethoxysilane) or the like which is stacked on the surface of the substrate 11 and in which an interconnect recess portion such as a groove is formed, a barrier metal film 13 provided to cover the surface of the insulating film 12 and the bottom and the inner wall of the interconnect recess portion and formed of a high-melting-point metal such as tantalum or tantalum nitride, and a copper film 14 formed of an interconnect material provided in the interconnect recess portion and formed on the barrier metal film 13.

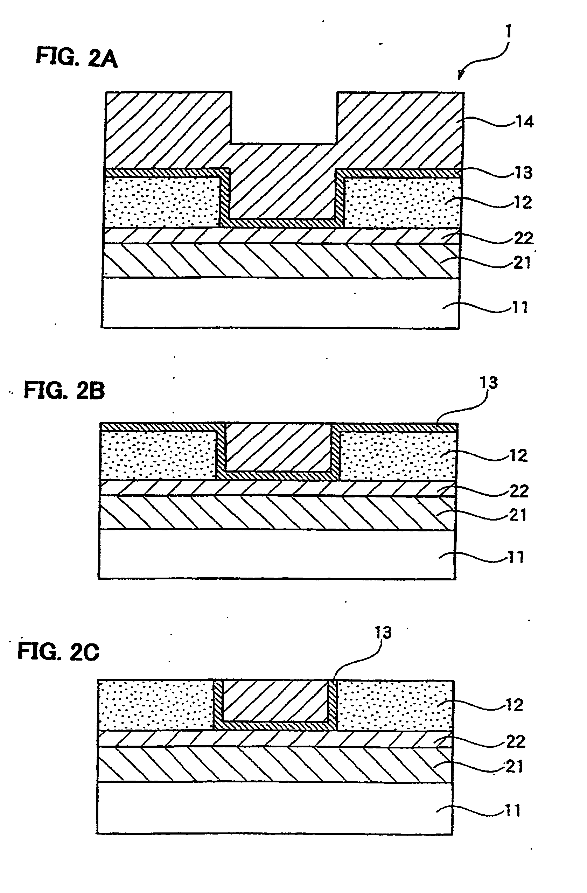

As shown in FIG. 2A, the polishing target of the chemical mechanical polishing method according to the second embodiment may include an insulating film 21 provided between the substrate 11 and the insulating film 12 and formed of silicon oxide or the like, and an insulating film 22 formed of silicon nitride or the like on the insulating film 21.

In the chemical mechanical polishing method according to the second embodiment, the polishing target (composite substrate material 1) may be polished according to the following procedure, for example. In the first polishing step, the metal material of the copper film 14 is chemically and mechanically polished using the first polishing aqueous dispersion in an area other than the metal interconnect provided in the interconnect recess portion until a specific surface (e.g. barrier metal film 13) is exposed (see FIGS. 1B and 2B). In the second polishing step, the barrier metal film 13 is chemically and mechanically polished using the chemical mechanical polishing aqueous dispersion according to the first embodiment so that the barrier metal film formed in the area other than the bottom and the inner wall of the interconnect recess portion is completely removed. The surface of the insulating film 12 is also polished in the second polishing step, whereby an accurately planarized damascene interconnect is obtained (see FIGS. 1C and 2C).

The first polishing aqueous dispersion has such polishing properties that the ratio ($R_{Cu}/R_{BM}$) of the polishing rate ($R_{Cu}$) of the copper film to the polishing rate ($R_{BM}$) of the barrier metal film is 50 or more and the ratio ($R_{Cu}/R_{In}$) of the polishing rate ($R_{Cu}$) of the copper film to the polishing rate ($R_{In}$) of the insulating film is 50 or more, as described above. The polishing rate ratio ($R_{Cu}/R_{BM}$) is preferably 60 or more, and still more preferably 70 or more. If the polishing rate ratio ($R_{Cu}/R_{BM}$) is less than 50, copper may remain to a large extent after the first polishing step in the area in which the copper film must be removed, whereby the second polishing step may require a longer polishing time. Moreover, a large amount of chemical mechanical polishing aqueous dispersion may be necessary.

The composition of the first polishing aqueous dispersion is not particularly limited insofar as the polishing rate ratio ($R_{Cu}/R_{BM}$) is in the above-mentioned range. It is preferable that the first polishing aqueous dispersion include abrasives, an organic acid, and an oxidizing agent in an aqueous medium, for example. It is still more preferable that the first polishing aqueous dispersion include ammonium or an ammonium ion in addition to these components.

As the aqueous medium used for the first polishing aqueous dispersion, the aqueous media given as examples for the specific aqueous dispersion according to the first embodiment can be given. It is preferable to use only water.

As the abrasives used for the first polishing aqueous dispersion, at least one type of abrasive selected from the abrasives given as examples for the specific aqueous dispersion according to the first embodiment may be used. Of these, silicon dioxide, organic particles, or organic-inorganic composite particles are preferably used.

As the organic acid used for the first polishing aqueous dispersion, at least one compound selected from amino acids and the compounds given as examples of the organic acid (B) for the specific aqueous dispersion according to the first embodiment may be used. Of these, glycine, alanine, citric acid, malic acid, 2-quinolinecarboxylic acid, or 2,3-pyridinedicarboxylic acid are preferably used, since a higher polishing rate ratio ($R_{Cu}/R_{BM}$) can be obtained.

As the oxidizing agent used for the first polishing aqueous dispersion, at least one compound selected from the compounds given as examples of the oxidizing agent (E) for the specific aqueous dispersion according to the first embodiment may be used. Of these, hydrogen peroxide or persulfate is preferable, with ammonium persulfate being particularly preferable.

The first polishing aqueous dispersion may further include ammonium or an ammonium ion. When the first polishing aqueous dispersion includes an ammonium ion, the ammonium ion may be produced from an ammonium salt of the above-mentioned organic acid or an ammonium salt of the above-mentioned inorganic acid as the oxidizing agent. Or, the ammonium ion may be added as the counter cation of the anionic surfactant which may be arbitrarily added.

The amount of the abrasives used in the first polishing aqueous dispersion is preferably 0.001 to 3 wt%, more preferably 0.01 to 3 wt%, still more preferably 0.01 to 2.5 wt%, and particularly preferably 0.01 to 2 wt% of the total amount of the first polishing aqueous dispersion.

The amount of the organic acid used in the first polishing aqueous dispersion is preferably 0.01 to 10 wt%, and still more preferably 0.1 to 5 wt% of the total amount of the first polishing aqueous dispersion.

The amount of the oxidizing agent used in the first polishing aqueous dispersion is preferably 0.01 to 10 wt%, and still more preferably 0.02 to 5 wt% of the total amount of the first polishing aqueous dispersion.

When the first polishing aqueous dispersion includes ammonia or an ammonium ion, the amount of ammonia or an ammonium ion used in the first polishing aqueous dispersion is preferably 5 mol/L or less, more preferably 0.01 to 5 mol/L, still more preferably 0.01 to 1 mol/L, and particularly preferably 0.03 to 0.5 mol/L.

The first polishing aqueous dispersion may arbitrarily include a surfactant, benzotriazole or a benzotriazole derivative, an anti-foaming agent, and the like.

As examples of the surfactant, a cationic surfactant, anionic surfactant, ampholytic surfactant, nonionic surfactant, water-soluble polymer, and the like can be given.

As the benzotriazole or benzotriazole derivative, the compounds given as examples of the benzotriazole or benzotriazole derivative (C) for the chemical mechanical polishing aqueous dispersion according to the first embodiment can be given. The amount of the benzotriazole or benzotriazole derivative used in the first polishing aqueous dispersion is preferably 5 wt% or less, more preferably 0.001 to 5 wt%, still more preferably 0.005 to 1 wt%, and particularly preferably 0.01 to 0.5 wt% of the total amount of the first polishing aqueous dispersion.

The pH of the first polishing aqueous dispersion may be set in the acidic region, the neutral region, or the alkaline region. When setting the pH of the first polishing aqueous dispersion in the acidic region, the pH of the first polishing aqueous dispersion is preferably 2.0 to 4.0. When setting the pH of the first polishing aqueous dispersion in the neutral region or the alkaline region, the pH of the first polishing aqueous dispersion is preferably 6.0 to 12.0. The pH of the first polishing aqueous dispersion is still more preferably 6.0 to 12.0.

Polishing using the chemical mechanical polishing method according to the second embodiment may be performed under known polishing conditions using a commercially available chemical mechanical polishing system (e.g. "LGP510" or "LGP552" manufactured by Lapmaster SFT Corporation, "EPO-112" or "EPO-222" manufactured by Ebara Corporation, "Mirra" manufactured by Applied Materials, Inc., or "AVANTI-472" manufactured by IPEC).

Preferable polishing conditions are appropriately set depending on the chemical mechanical polishing system used. For example, when using "EPO-112" as the chemical mechanical polishing system, the first polishing step and the second polishing step may be carried out under the following conditions.

Platen rotational speed: preferably 30 to 120 rpm, and more preferably 40 to 100 rpm
Head rotational speed: preferably 30 to 120 rpm, and more preferably 40 to 100 rpm
Platen rotational speed/head rotational speed: preferably 0.5 to 2, and more preferably 0.7 to 1.5
Polishing pressure: preferably 100 to 500 g/cm$^2$, and more preferably 200 to 350 g/cm$^2$
Supply rate of chemical mechanical polishing aqueous dispersion: preferably 50 to 300 ml/min, and more preferably 100 to 200 ml/min

3. Examples

The invention is described below by way of examples. Note that the invention is not limited to the following examples.

3.1. Preparation of aqueous dispersion containing inorganic particles

3.1.1. Preparation of aqueous dispersion containing fumed silica particles

2 kg of fumed silica particles ("Aerosil #90" manufactured by Nippon Aerosil Co., Ltd., average primary particle diameter: 20 nm) were dispersed in 6.7 kg of ion-exchanged water using an ultrasonic mixer. The mixture was filtered through a filter having a pore diameter of 5 microns to obtain an aqueous dispersion containing fumed silica particles. The average secondary particle diameter of the fumed silica in the resulting aqueous dispersion was 220 nm.

3.2. Preparation of aqueous dispersion containing colloidal silica particles

3.2.1. Preparation of aqueous dispersion containing colloidal silica particles C 1

A flask was charged with 70 parts by weight of 25 wt% aqueous ammonia, 40 parts by weight of ion-exchanged water, 170 parts by weight of ethanol, and 20 parts by weight of tetraethoxysilane. The mixture was heated to 60°C with stirring at a rotational speed of 180 rpm. After stirring the mixture at 60°C for two hours, the mixture was cooled to room temperature. An alcohol dispersion of colloidal silica particles was thus obtained.

An operation of removing the alcohol from the resulting dispersion at 80°C using a rotary evaporator while adding ion-exchanged water was performed several times. An aqueous dispersion containing 20 wt% of colloidal silica particles C1 was prepared in this manner.

The average primary particle diameter, the average secondary particle diameter, and the average degree of association of the colloidal silica particles C1 in the resulting aqueous dispersion were respectively 25 nm, 40 nm, and 1.6.

3.2.2. Preparation of aqueous dispersions respectively containing colloidal silica particles C2 to C5

Aqueous dispersions respectively containing colloidal silica particles C2 to C5 were prepared in the same manner as in "3.2.1. Preparation of aqueous dispersion containing colloidal silica particles C1" except for changing the amounts of the 25wt% aqueous ammonia, ethanol, and tetraethoxysilane as shown in Table 1.

TABLE 1

| Colloidal silica | Amount of raw material | | | Colloidal silica content of aqueous dispersion wt% dispersion (wt%) | Average primary Average primary particle diameter nm | Average secondary particle diameter (nm) | Degree of association |
|---|---|---|---|---|---|---|---|
| | 25wt% aqueous ammonia (part by weight) | Ethanol (part by weight) | Tetraethoxysilane (part by weight) | | | | |
| C 1 | 70 | 170 | 20 | 20.0 | 25 | 40 | 1.6 |
| C2 | 70 | 175 | 25 | 20.0 | 35 | 55 | 1.6 |
| C3 | 65 | 175 | 25 | 20.0 | 35 | 70 | 2.0 |
| C4 | 60 | 190 | 35 | 20.0 | 50 | 105 | 2.1 |
| C5 | 55 | 195 | 40 | 20.0 | 70 | 200 | 2.9 |

3.3. Preparation of aqueous dispersion containing organic-inorganic composite particles

3.3.1. Preparation of aqueous dispersion containing surface-treated organic particles

A flask was charged with 90 parts by weight of methyl methacrylate, 5 parts by weight of methoxy polyethylene glycol methacrylate ("NK Ester M-90G #400" manufactured by Shin-Nakamura Chemical Co., Ltd.), 5 parts by weight of 4-vinylpyridine, 2 parts by weight of an azo initiator ("V50" manufactured by Wako Pure Chemical Industries, Ltd.), and 400 parts by weight of ion-exchanged water. The mixture was heated to 70°C with stirring in a nitrogen gas atmosphere. The mixture was allowed to stand at 70°C for six hours with stirring. The reaction mixture was diluted with ion-exchanged water to obtain an aqueous dispersion containing 10 wt% of polymethyl methacrylate particles having a functional group containing a cation of an amino group and a polyethylene glycol chain and having an average particle diameter of 150 nm. The polymerization yield was 95%.

A flask was charged with 100 parts by weight of the resulting aqueous dispersion. After the addition of 1 part by weight of methyltrimethoxysilane, the mixture was stirred at 40°C for two hours. The pH of the mixture was adjusted to 2.0 by adding a 1N nitric acid aqueous solution to obtain an aqueous dispersion containing surface-treated organic particles. The zeta potential of the surface-treated organic particles in the resulting aqueous dispersion was +17 mV

3.3.2. Preparation of aqueous dispersion containing inorganic particles (colloidal silica particles)

Colloidal silica particles ("Snowtex O" manufactured by Nissan Chemical Industries, Ltd., average primary particle diameter: 12 nm) were dispersed in water. The pH of the mixture was adjusted using a 1N potassium hydroxide aqueous solution to obtain an aqueous dispersion containing 10 wt% of colloidal silica particles and having a pH of 8.0.

The zeta potential of the colloidal silica particles in the resulting aqueous dispersion was -40 mV

3.3.3. Preparation of aqueous dispersion containing organic-inorganic composite particles

50 parts by weight of the aqueous dispersion prepared in "3.3.2. Preparation of aqueous dispersion containing inorganic particles (colloidal silica particles)" was slowly added to 100 parts by weight of the aqueous dispersion prepared in "3.3.1. Preparation of aqueous dispersion containing surface-treated organic particles" in two hours with stirring. The mixture was then stirred for two hours to obtain an aqueous dispersion containing particles in which the silica particles adhered to the polymethyl methacrylate particles.

After the addition of 2 parts by weight of vinyltriethoxysilane to the resulting aqueous dispersion, the mixture was stirred for one hour. Then, 1 part by weight of tetraethoxysilane was added to the mixture. After stirring the mixture at 60°C for three hours, the mixture was cooled to room temperature to prepare an aqueous dispersion containing 10 wt% of organic-inorganic composite particles having an average particle diameter of 180 nm.

The organic-inorganic composite particles in the resulting aqueous dispersion were observed using a scanning electron microscope. As a result, it was found that the silica particles adhered to 80% of the surface of the polymethyl methacrylate particle.

3.4. Preparation of aqueous solution containing polyacrylate

3.4.1. Preparation of aqueous solution containing polyacrylate P1

500g of a 20 wt% acrylic acid aqueous solution was uniformly added dropwise to a 2-liter container containing 1,000 g of ion-exchanged water and 10 g of a 5 wt% ammonium persulfate aqueous solution in 10 hours with stirring under reflux. After the addition, the mixture was allowed to stand for two hours under reflux to obtain an aqueous solution containing polyacrylic acid having a weight average molecular weight (Mw) of 12,000.

The resulting aqueous solution was neutralized by slowly adding 25 wt% aqueous ammonia to prepare an aqueous solution having a pH of 7.5 and containing 12 wt% of polyacrylate P1 (ammonium polyacrylate having a weight average molecular weight (Mw) of 12,000).

3.4.2. Preparation of aqueous solutions respectively containing polyacrylates P2 to P4

Aqueous solutions having a pH of 7.5 and respectively containing 12 wt% of polyacrylates P2 to P4 (ammonium polyacrylate or potassium polyacrylate) were prepared in the same manner as in "3.4.1. Preparation of aqueous solution containing polyacrylate P1" except for changing the amount of ammonium persulfate and the type of neutralizer as shown in Table 2.

TABLE 2

| | | Polyacrylate | | | |
|---|---|---|---|---|---|
| | | P1 | P2 | P3 | P4 |
| | Amount of ammonium persulfate (g) | 10 | 5 | 10 | 5 |
| | Neutralizer | 25 wt% aqueous ammonia | 25 wt% aqueous ammonia | 20 wt% KOH aqueous solution | 20 wt% KOH aqueous solution |
| | Weight average molecular weight | 12,000 | 65,000 | 12,000 | 65,000 |
| | Counter cation | Ammonium ion | Ammonium ion | Potassium ion | Potassium ion |

3.5. Preparation of first polishing aqueous dispersion and evaluation of polishing performance

3.5.1. Preparation of first polishing aqueous dispersion

2 kg of fumed silica particles ("Aerosil #90" manufactured by Nippon Aerosil Co., Ltd., primary particle diameter: 20 nm, secondary particle diameter: 220 nm) were dispersed in 6.7 kg of ion-exchanged water using an ultrasonic mixer. The mixture was filtered through a filter having a pore diameter of 5 microns to obtain an aqueous dispersion containing 23.0 wt% of fumed silica particles.

Then, a polyethylene container was charged with the resulting aqueous dispersion in such an amount that the weight of silica was 1.2 wt%. After the addition of 0.5 wt% of quinaldic acid, 0.05 wt% of "Surfynol 465" (manufactured by Air Products Japan, Inc., nonionic surfactant having a triple bond), and 1.0 wt% of ammonium persulfate, the mixture was diluted with ion-exchanged water. The mixture was then sufficiently stirred. After adjusting the pH of the mixture to 9.5 using a 1N potassium hydroxide aqueous solution, the mixture was filtered through a filter having a pore diameter of 5 microns to obtain a first polishing aqueous dispersion.

3.5.2. Evaluation of polishing performance of first polishing aqueous dispersion

3.5.2-1. Chemical mechanical polishing experiment of unpatterned wafer

A polishing pad made of porous polyurethane ("IC1000" manufactured by Nitta Haas Inc.) was installed in a chemical mechanical polishing system ("EPO-112" manufactured by Ebara Corporation). Polishing rate measurement substrates given below were chemically and mechanically polished for one minute under polishing conditions given below while supplying the first polishing aqueous dispersion, and the polishing rate was calculated by a method given below.

(i) Polishing rate measurement substrate

- A substrate in which a copper film having a thickness of 15,000 angstroms was provided on an 8-inch silicon substrate with a thermal oxide film.
- A substrate in which a tantalum film having a thickness of 2,000 angstroms was provided on an 8-inch silicon substrate with a thermal oxide film.
- A substrate in which a tantalum nitride film having a thickness of 2,000 angstroms was provided on an 8-inch silicon substrate with a thermal oxide film.
- A substrate in which a PETEOS film having a thickness of 10,000 angstroms was provided on an 8-inch silicon substrate.

(ii) Polishing conditions

- Head rotational speed: 70 rpm
- Head load: 250 g/cm$^2$
- Platen rotational speed: 70 rpm
- Supply rate of first polishing aqueous dispersion: 200 ml/min

(iii) Calculation of polishing rate

The thickness after polishing was measured using an electric conduction type thickness measurement device ("OmniMap RS75" manufactured by KLA-Tencor Corporation), and the polishing rate was calculated from the thickness reduced by chemical mechanical polishing and the polishing time.

The thicknesses of the copper film, the tantalum film, and the tantalum nitride film was measured after polishing using an electric conduction type thickness measurement device ("OmniMap RS75" manufactured by KLA-Tencor Corporation), and the polishing rate was calculated from the thickness reduced by chemical mechanical polishing and the polishing time.

The thickness of the PETEOS film was measured after polishing using an optical interference type thickness measurement device ("FPT500" manufactured by SENTEC), and the polishing rate was calculated from the thickness reduced by chemical mechanical polishing and the polishing time.

(iv) Polishing rate

- Polishing rate of copper film ($R_{Cu}$): 5200 angstroms/min
- Polishing rate of tantalum film ($R_{BM}$): 30 angstroms/min
- Polishing rate of tantalum nitride film ($R_{BM}$): 40 angstroms/min
- Polishing rate of PETEOS film ($R_{In}$): 20 angstroms/min
- Polishing rate of copper film/polishing rate of tantalum film ($R_{Cu}/R_{BM}$): 173
- Polishing rate of copper film/polishing rate of tantalum nitride film ($R_{Cu}/R_{BM}$): 130
- Polishing rate of copper film/polishing rate of PETEOS film ($R_{Cu}/R_{In}$): 260

3.5.2-2. Chemical mechanical polishing experiment of patterned substrate

A polishing pad made of porous polyurethane ("IC 1000" manufactured by Nitta Haas Inc.) was installed in a chemical mechanical polishing system ("EPO-112" manufactured by Ebara Corporation). Two patterned substrates given below were chemically and mechanically polished under polishing conditions given below while supplying the first polishing aqueous dispersion.

(i) Patterned substrate

- "854 CMP 100" manufactured by SEMATECH; substrate obtained by forming recess portions of various patterns in a silicon substrate and stacking a tantalum film (thickness: 250 angstroms), a copper seed film (thickness: 1,000 angstroms), and a copper plating film (thickness: 10,000 angstroms) over the recess portions in that order.
- "854 CMP 101" manufactured by SEMATECH; substrate obtained by forming recess portions of various patterns in a silicon substrate and stacking a tantalum nitride film (thickness: 250 angstroms), a copper seed film (thickness: 1,000 angstroms), and a copper plating film (thickness: 10,000 angstroms) over the recess portions in that order.

(ii) Polishing conditions

- Head rotational speed: 70 rpm
- Head load: 250 g/cm$^2$
- Platen rotational speed: 70 rpm
- Supply rate of first polishing aqueous dispersion: 200 ml/min
- Polishing time: 2.75 min

It is estimated that, after the first polishing step, the entire copper film positioned above the barrier metal is removed so that the upper surface of the barrier metal is exposed.

After the first polishing step, the depth of dishing occurring in the copper interconnect area of the polished surface having a width of 100 microns was measured using a surface roughness meter ("P-10" manufactured by KLA-Tencor Corporation). As a result, the depth of dishing was 500 angstroms.

The term "dishing" used herein refers to the difference in height of the polished surface between the upper surface of the barrier metal film on each side of the copper interconnect at the measurement position and the lowest portion of the copper interconnect at the measurement position.

The copper interconnect area was observed for 200 unit areas (120×120 microns) at random by darkfield illumination using an optical microscope to measure the number of unit areas in which scratches had occurred (number of scratches). As a result, the number of scratches was zero.

3.6. Example 1

3.6.1. Preparation of second polishing aqueous dispersion (chemical mechanical polishing aqueous dispersion according to the first embodiment of the invention)

A polyethylene bottle was charged with the aqueous dispersion containing the colloidal silica particles C1 prepared in "3.2.1. Preparation of aqueous dispersion containing colloidal silica particles C1" in such an amount that the amount of silica was 2 wt% and the aqueous dispersion containing fumed silica prepared in "3.1.1. Preparation of aqueous dispersion containing fumed silica particles" in such an amount that the amount of silica was 2 wt%. After the addition of 0.1 wt% of benzotriazole, 0.2 wt% of quinaldic acid, the aqueous solution containing the ammonium polyacrylate P2 prepared in "Preparation of aqueous solution containing polyacrylate" in such an amount that the amount of polymer was 0.1 wt%, and a 35 wt% hydrogen peroxide aqueous solution in such an amount that the amount of hydrogen peroxide was 0.6 wt%, the mixture was stirred for 15 minutes. After the addition of ion-exchanged water so that the total amount of the components was 100 wt%, the mixture was filtered through a filter having a pore diameter of 5 microns to obtain a second polishing aqueous dispersion S1 having a pH of 4.0.

3.6.2. Evaluation of polishing performance of second polishing aqueous dispersion

3.6.2-1. Polishing experiment of unpatterned substrate

A polishing pad made of porous polyurethane ("IC1000" manufactured by Nitta Haas Inc.) was installed in a chemical mechanical polishing system ("EPO-112" manufactured by Ebara Corporation). Polishing rate measurement substrates given below were chemically and mechanically polished for one minute under polishing conditions given below while supplying the second polishing aqueous dispersion, and the polishing rate was calculated by a method given below.

(i) Polishing rate measurement substrate

- A substrate in which a copper film having a thickness of 15,000 angstroms was provided on an 8-inch silicon substrate with a thermal oxide film.
- A substrate in which a tantalum film having a thickness of 2,000 angstroms was provided on an 8-inch silicon substrate with a thermal oxide film.
- A substrate in which a tantalum nitride film having a thickness of 2,000 angstroms was provided on an 8-inch silicon substrate with a thermal oxide film.
- A substrate in which a PETEOS film having a thickness of 10,000 angstroms was provided on an 8-inch silicon substrate.

(ii) Polishing conditions

- Head rotational speed: 70 rpm
- Head load: 250 g/cm$^2$
- Platen rotational speed: 70 rpm
- Supply rate of second polishing aqueous dispersion: 200 ml/min

(iii) Calculation of polishing rate

The thicknesses of the copper film, the tantalum film, and the tantalum nitride film was measured after polishing using an electric conduction type thickness measurement device ("OmniMap RS75" manufactured by KLA-Tencor Corporation), and the polishing rate was calculated from the thickness reduced by chemical mechanical polishing and the polishing time.

The thickness of the PETEOS film was measured after polishing using an optical interference type thickness measurement device ("FPT500" manufactured by SENTEC), and the polishing rate was calculated from the thickness reduced by chemical mechanical polishing and the polishing time.

(iv) Polishing rate

- Polishing rate of copper film ($R_{Cu}$): 580 angstroms/min
- Polishing rate of tantalum film ($R_{BM}$): 490 angstroms/min
- Polishing rate of tantalum nitride film ($R_{BM}$): 630 angstroms/min
- Polishing rate of PETEOS film ($R_{In}$): 530 angstroms/min
- Polishing rate of tantalum film/polishing rate of copper film ($R_{BM}(Ta)/R_{Cu}$): 0.84
- Polishing rate of tantalum nitride film/polishing rate of copper film ($R_{BM}(TaN)/R_{Cu}$): 1.09
- Polishing rate of PETEOS film/polishing rate of copper film ($R_{In}/R_{Cu}$): 0.91

3.6.3. Polishing test of patterned substrate

3.6.3-1. Polishing test when polishing time of second polishing step is short

A polishing pad made of porous polyurethane ("IC 1000" manufactured by Nitta Haas Inc.) was installed in a chemical mechanical polishing system ("EPO-112" manufactured by Ebara Corporation). Two patterned substrates given below were chemically and mechanically polished in two stages under polishing conditions given below.

(i) Patterned substrate

- "854 CMP 100" manufactured by SEMATECH; substrate obtained by forming recess portions of various patterns in a silicon substrate and stacking a tantalum film (thickness: 250 angstroms), a copper seed film (thickness: 1,000 angstroms), and a copper plating film (thickness: 10,000 angstroms) over the recess portions in that order.
- "854 CMP 101" manufactured by SEMATECH; substrate obtained by forming recess portions of various patterns in a silicon substrate and stacking a tantalum nitride film (thickness: 250 angstroms), a copper seed film (thickness: 1,000 angstroms), and a copper plating film (thickness: 10,000 angstroms) over the recess portions in that order.

(ii) Polishing conditions for first polishing step

- Chemical mechanical polishing aqueous dispersion: first polishing aqueous dispersion prepared in "3.5.1. Preparation of first polishing aqueous dispersion"
- Supply rate of first polishing aqueous dispersion: 200 ml/min
- Head rotational speed: 70 rpm
- Head load: 250 g/cm$^2$
- Platen rotational speed: 70 rpm
- Polishing time: 2.75 min

(iii) Polishing conditions for second polishing step

- Chemical mechanical polishing aqueous dispersion: second polishing aqueous dispersion prepared in "3.6.1. Preparation of second polishing aqueous dispersion (chemical mechanical polishing aqueous dispersion according to the first embodiment of the invention)"
- Supply rate of second polishing aqueous dispersion: 200 ml/min
- Head rotational speed: 70 rpm
- Head load: 250 g/cm$^2$
- Platen rotational speed: 70 rpm
- Polishing time: 1.51 min for "854 CMP 100" and 1.40 min for "854 CMP 101"

The polishing time was calculated by the following equation.

$$\text{Polishing time (min)} = \{\text{thickness of barrier metal layer (angstrom) / polishing rate (angstrom/min) of barrier metal film (tantalum or tantalum nitride) calculated in "3.6.2-1. Polishing experiment of unpatterned substrate"}\} + 1 \text{ (min)}$$

It is estimated that, after the second polishing step, the entire barrier metal film positioned above the uppermost surface of the PETEOS film is removed so that the upper surface of the PETEOS film is exposed.

After the second polishing step, the depth of dishing occurring in the copper interconnect area of the polished surface having a width of 100 microns was measured using a surface roughness meter ("P-10" manufactured by KLA-Tencor Corporation). As a result, the depth of dishing was 290 angstroms for "854 CMP 100" and 260 angstroms for "854 CMP 101".

The term "dishing" used herein refers to the difference in height at the polished surface between the upper surface of the PETEOS film on each side of the copper interconnect at the measurement position and the lowest portion of the copper interconnect at the measurement position.

The copper interconnect area was observed for 200 unit areas (120×120 microns) at random by darkfield illumination using an optical microscope to measure the number of unit areas in which scratches had occurred (number of scratches). As a result, the number of scratches was two for "854 CMP 100" and one for "854 CMP 101".

3.6.3-2. Polishing test when polishing time of second polishing step is long

The patterned substrates were chemically and mechanically polished in two stages in the same manner as in "3.6.3-1. Polishing test when polishing time of second polishing step is short" except for calculating the polishing time of the second polishing step by the following equation.

Polishing time of second polishing step (min) = {thickness of barrier metal layer (angstrom) / polishing rate (angstrom/min) of barrier metal film (tantalum or tantalum nitride) calculated in "3.6.2-1. Polishing experiment of unpatterned substrate"} + 2 (min)

The polished surface after the two-stage polishing was evaluated for dishing and scratches in the same manner as in "3.6.3-1. Polishing test when polishing time of second polishing step is short". As a result, the depth of dishing and the number of scratches were respectively 310 angstroms and one for "854 CMP 100", and the depth of dishing and the number of scratches were respectively 270 angstroms and zero for "854 CMP 101".

3.7. Examples 2 to 8 and Comparative Example 1

Second polishing aqueous dispersions S2 to S8 and R1 were prepared in the same manner as in Example 1 except for changing the type and amount of each component of the second polishing aqueous dispersion and the pH of the aqueous dispersion as shown in Table 3. In Table 3, the symbol "-" indicates that the corresponding component was not added. The "component (C)" indicates the benzotriazole or benzotriazole derivative (C), and the "component (D)" indicates the poly(meth)acrylate (D). In Examples 4 and 5, two types of particles were used as the abrasives (A).
The polishing performance was evaluated in the same manner as in Example 1 except for using each aqueous dispersion prepared as the second polishing aqueous dispersion instead of the chemical mechanical polishing aqueous dispersion S1. The results are shown in Table 4.

TABLE 3

| | Aqueous dispersion | Abrasives (A) | | Organic acid (B) | | Component (C) | | Component (D) | | Oxidizing agent (E) | | pH |
|---|---|---|---|---|---|---|---|---|---|---|---|---|
| | | Type | Amount (wt%) | Type | Amount (wt%) | Type | Amount (wt%) | Type | Amount (wt%) | Type | Amount (wt%) | |
| Examples 1 | S1 | C1 Fumed silica | 2.0 2.0 | Quinaldic acid | 0.20 | Benzotriazole | 0.10 | P2 | 0.10 | Hydrogen peroxide | 0.6 | 4.0 |
| Examples 2 | S2 | C5 | 2.0 | Maleic acid | 0.35 | Benzotriazole | 0.05 | P1 | 0.10 | Hydrogen peroxide | 0.2 | 2.3 |
| Example 3 | S3 | C2 | 5.0 | Quinolinic acid | 0.15 | Benzotriazole | 0.20 | P2 | 0.02 | Hydrogen peroxide | 0.4 | 2.9 |
| Example 4 | S4 | C1 C4 | 3.0 3.0 | Citric acid | 0.50 | Benzotriazole | 0.02 | P1 | 0.30 | Hydrogen peroxide | 0.1 | 3.5 |
| Example 5 | S5 | C3 Composite particle | 3.0 3.0 | Quinolinic acid | 0.40 | Benzotriazole | 0.30 | P1 | 0.05 | Hydrogen peroxide | 1.0 | 3.3 |
| Example 6 | S6 | C2 | 5.0 | Malic acid | 0.25 | Benzotriazole | 0.10 | P1 | 0.20 | Hydrogen peroxide | 0.3 | 3.0 |
| Example 7 | S7 | C5 | 2.0 | Maleic acid | 0.35 | Benzotriazole | 0.05 | P3 | 0.10 | Hydrogen peroxide | 0.2 | 2.3 |
| Example 8 | S8 | C2 | 5.0 | Quinolinic acid | 0.15 | Benzotriazole | 0.20 | P4 | 0.02 | Hydrogen peroxide | 0.4 | 2.9 |
| Comparative Example 1 | R1 | C4 | 3.0 | Oxalic acid | 0.10 | Benzotriazole | 0.05 | - | - | Hydrogen peroxide | 0.5 | 5.8 |

TABLE 4

| | Example 1 | Example 2 | Example 3 | Example 4 | Example 5 | Example 6 | Example 7 | Example 8 | Comparative Example 1 |
|---|---|---|---|---|---|---|---|---|---|
| Second polishing aqueous dispersion | S1 | S2 | S3 | S4 | S5 | S6 | S7 | S8 | R1 |
| Polishing of unpatterned film | | | | | | | | | |
| $R_{Cu}$(A/min) | 580 | 770 | 610 | 380 | 650 | 420 | 750 | 600 | 1530 |
| $R_{BM}$ (Ta)(A/min) | 490 | 510 | 690 | 550 | 750 | 550 | 510 | 690 | 290 |
| $R_{BM}$ (TaN) (A/min) | 630 | 670 | 920 | 730 | 1090 | 610 | 675 | 925 | 350 |
| $R_{In}$ (insulating film) (A/min) | 530 | 450 | 630 | 480 | 510 | 620 | 450 | 630 | 250 |
| $R_{BM}$ (Ta)/$R_{Cu}$ | 0.84 | 0.67 | 1.13 | 1.45 | 1.15 | 1.31 | 0.68 | 1.15 | 0.19 |
| $R_{BM}$(TaN)/ $R_{Cu}$ | 1.09 | 0.87 | 1.51 | 1.92 | 1.68 | 1.45 | 0.9 | 1.54 | 0.23 |
| $R_{In}$/$R_{Cu}$ | 0.91 | 0.58 | 1.03 | 1.26 | 0.78 | 1.48 | 0.6 | 1.05 | 0.16 |
| Polishing of patterned film | | | | | | | | | |
| Barrier metal = Ta | | | | | | | | | |
| Short second polishing time | | | | | | | | | |
| Second polishing time (min) | 1.51 | 1.49 | 1.36 | 1.45 | 1.33 | 1.45 | 1.49 | 1.36 | 1.86 |
| Dishing (A) | 290 | 460 | 150 | 220 | 380 | 370 | 450 | 140 | 1500 |
| Scratches (number) | 2 | 0 | 0 | 1 | 0 | 0 | 0 | 0 | 32 |
| Long second polishing time | | | | | | | | | |
| Second polishing time (min) | 2.51 | 2.49 | 2.36 | 2.45 | 2.33 | 2.45 | 2.49 | 2.36 | 2.86 |
| Dishing (A) | 310 | 470 | 140 | 250 | 380 | 360 | 470 | 130 | 2800 |
| Scratches (number) | 1 | 0 | 1 | 1 | 0 | 1 | 0 | 0 | 43 |
| Barrier metal = TaN | | | | | | | | | |

(continued)

| | Example 1 | Example 2 | Example 3 | Example 4 | Example 5 | Example 6 | Example 7 | Example 8 | Comparative Example 1 |
|---|---|---|---|---|---|---|---|---|---|
| Short second polishing time | | | | | | | | | |
| Second polishing time (min) | 1.40 | 1.37 | 1.27 | 1.34 | 1.23 | 1.41 | 1.37 | 1.27 | 1.71 |
| Dishing (A) | 260 | 390 | 140 | 190 | 350 | 350 | 380 | 140 | 1250 |
| Scratches (number) | 1 | 0 | 1 | 1 | 0 | 1 | 0 | 0 | 43 |
| Long second polishing time | | | | | | | | | |
| Second polishing time (min) | 2.40 | 2.37 | 2.27 | 2.34 | 2.23 | 2.41 | 2.37 | 2.27 | 2.71 |
| Dishing (A) | 270 | 410 | 110 | 230 | 340 | 360 | 400 | 100 | 2550 |
| Scratches (number) | 0 | 0 | 1 | 0 | 0 | 0 | 0 | 1 | 45 |

As is clear from Tables 3 and 4, it was found that occurrence of scratches on the polishing target surface can be reduced and a sufficiently planarized polished surface can be obtained with high accuracy, even if polishing is performed for a period of time greater than the optimum polishing time, by using the chemical mechanical polishing aqueous dispersion according to the first embodiment of the invention as the second polishing aqueous dispersion.

3.8. Example 9

3.8.1. Preparation of second polishing aqueous dispersion (kit for preparing the chemical mechanical polishing aqueous dispersion according to the first embodiment of the invention)

3.8.1-1. Preparation of liquid (I)

A polyethylene bottle was charged with the aqueous dispersion containing the colloidal silica particles C1 prepared in "3.2.1. Preparation of aqueous dispersion containing colloidal silica particles C1" in such an amount that the amount of silica was 2.27wt% and the aqueous dispersion containing fumed silica prepared in "3.1.1. Preparation of aqueous dispersion containing fumed silica particles" in such an amount that the amount of silica was 2.27wt%. After the addition of 0.11 wt% of benzotriazole, 0.23wt% of quinaldic acid, and the aqueous solution containing the ammonium polyacrylate P2 prepared in "Preparation of aqueous solution containing polyacrylate" in such an amount that the amount of polymer was 0.11 wt%, the mixture was stirred for 15 minutes. After the addition of ion-exchanged water so that the total amount of the components was 100 wt%, the mixture was filtered through a filter having a pore diameter of 5 microns to obtain a liquid (I) A1 (aqueous dispersion).

3.8.1-2. Preparation of liquid (II)

The hydrogen peroxide concentration was adjusted to 5 wt% using ion-exchanged water to obtain a liquid (II) B1.

3.8.2. Evaluation of polishing performance of second polishing aqueous dispersion

100 parts by weight of the liquid (I) A1 and 13.64 parts by weight of the liquid (II) B 1 prepared as described above were mixed to prepare a chemical mechanical polishing aqueous dispersion S9. The pH of the chemical mechanical polishing aqueous dispersion S9 was 4.0. Since the chemical mechanical polishing aqueous dispersion S9 has the same composition and pH as those of the chemical mechanical polishing aqueous dispersion S1 prepared in Example 1, the chemical mechanical polishing aqueous dispersion S9 can be considered to be the same as the chemical mechanical polishing aqueous dispersion S 1 prepared in Example 1.

The polishing performance was evaluated in the same manner as in Example 1 except for using the chemical mechanical polishing aqueous dispersion S9 prepared as described above as the second polishing aqueous dispersion instead of the chemical mechanical polishing aqueous dispersion S1. The results were the same as those of Example 1.

3.9. Example 10

3.9.1. Preparation of second polishing aqueous dispersion (kit for preparing the chemical mechanical polishing aqueous dispersion according to the first embodiment of the invention)

3.9.1-1. Preparation of liquid (I)

A polyethylene bottle was charged with the aqueous dispersion containing the colloidal silica particles C1 prepared in "3.2.1. Preparation of aqueous dispersion containing colloidal silica particles C1" in such an amount that the amount of silica was 4 wt% and the aqueous dispersion containing fumed silica prepared in "3.1.1. Preparation of aqueous dispersion containing fumed silica particles" in such an amount that the amount of silica was 4 wt%. After the addition of the aqueous solution containing the ammonium polyacrylate P2 prepared in "Preparation of aqueous solution containing polyacrylate" in such an amount that the amount of polymer was 0.2 wt% and a 35 wt% hydrogen peroxide aqueous solution in such an amount that the amount of hydrogen peroxide was 1.2 wt%, the mixture was stirred for 15 minutes. After the addition of ion-exchanged water so that the total amount of the components was 100 wt%, the mixture was filtered through a filter having a pore diameter of 5 microns to obtain a liquid (I) A2 (aqueous dispersion).

3.9.1-2. Preparation of liquid (II)

A polyethylene bottle was charged with 0.2 wt% of benzotriazole and 0.4 wt% of quinaldic acid. The mixture was stirred for 15 minutes. After the addition of ion-exchanged water so that the total amount of the components was 100 wt%, the mixture was filtered through a filter having a pore diameter of 5 microns to obtain a liquid (II) A3 (aqueous dispersion).

3.9.2. Evaluation of polishing performance of second polishing aqueous dispersion

50 parts by weight of the liquid (I) A2 and 50 parts by weight of the liquid (II) A3 prepared as described above were mixed to prepare a chemical mechanical polishing aqueous dispersion S10. The pH of the chemical mechanical polishing aqueous dispersion S 10 was 4.0. Since the chemical mechanical polishing aqueous dispersion S10 has the same composition and pH as those of the chemical mechanical polishing aqueous dispersion S1 prepared in Example 1, the chemical mechanical polishing aqueous dispersion S10 can be considered to be the same as the chemical mechanical polishing aqueous dispersion S 1 prepared in Example 1.

The polishing performance was evaluated in the same manner as in Example 1 except for using the chemical mechanical polishing aqueous dispersion S10 prepared as described above as the second polishing aqueous dispersion instead of the chemical mechanical polishing aqueous dispersion S1. The results were the same as those of Example 1.

3.10. Example 11

3.10.1. Preparation of second polishing aqueous dispersion (kit for preparing the chemical mechanical polishing aqueous dispersion according to the first embodiment of the invention)

3.10.1-1. Preparation of liquid (I)

A polyethylene bottle was charged with the aqueous dispersion containing the colloidal silica particles C1 prepared in "3.2.1. Preparation of aqueous dispersion containing colloidal silica particles C1" in such an amount that the amount of silica was 4.55 wt% and the aqueous dispersion containing fumed silica prepared in "3.1.1. Preparation of aqueous dispersion containing fumed silica particles" in such an amount that the amount of silica was 4.55 wt%. After the addition of the aqueous solution containing the ammonium polyacrylate P2 prepared in "Preparation of aqueous solution containing polyacrylate" in such an amount that the amount of polymer was 0.23wt%, the mixture was stirred for 15 minutes. After the addition of ion-exchanged water so that the total amount of the components was 100 wt%, the mixture was filtered through a filter having a pore diameter of 5 microns to obtain a liquid (I) A4 (aqueous dispersion).

3.10.1-2. Preparation of liquid (II)

A polyethylene bottle was charged with 0.23 wt% of benzotriazole and 0.45 wt% of quinaldic acid. The mixture was stirred for 15 minutes. After the addition of ion-exchanged water so that the total amount of the components was 100 wt%, the mixture was filtered through a filter having a pore diameter of 5 microns to obtain a liquid (II) A5 (aqueous dispersion).

3.10.2. Evaluation of polishing performance of second polishing aqueous dispersion

50 parts by weight of the liquid (I) A4 and 50 parts by weight of the liquid (II) A5 and 13.64 parts by weight of the liquid (III) B1 prepared as described above were mixed to prepare a chemical mechanical polishing aqueous dispersion S11. The pH of the chemical mechanical polishing aqueous dispersion S11 was 4.0. Since the chemical mechanical polishing aqueous dispersion S11 has the same composition and pH as those of the chemical mechanical polishing aqueous dispersion S1 prepared in Example 1, the chemical mechanical polishing aqueous dispersion S11 can be considered to be the same as the chemical mechanical polishing aqueous dispersion S 1 prepared in Example 1.

The polishing performance was evaluated in the same manner as in Example 1 except for using the chemical mechanical polishing aqueous dispersion S11 prepared as described above as the second polishing aqueous dispersion instead of the chemical mechanical polishing aqueous dispersion S1. The results were the same as those of Example 1.

Although only some embodiments of the invention have been described in detail above, those skilled in the art will readily appreciate that many modifications are possible in the embodiments without departing from the novel teachings and advantages of this invention. Accordingly, all such modifications are intended to be included within the scope of this invention.

A chemical mechanical polishing aqueous dispersion, including: (A) abrasives; (B) an organic acid; (C) benzotriazole or a benzotriazole derivative; (D) a poly(meth)acrylate; (E) an oxidizing agent; and (F) water, the abrasives (A) being included in the chemical mechanical polishing aqueous dispersion in an amount of 2 to 10 wt%.

**EP 1 700 893 B1**

**Claims**

1. A chemical mechanical polishing aqueous dispersion for polishing a copper film, a barrier metal film, and an insulating film at the same time chemically and mechanically, having a pH of 1.0 to 5.0, comprising:

   (A) abrasives;
   (B) an organic acid;
   (C) benzotriazole or a benzotriazole derivative;
   (D) an ammonium or potassium salt of polyacrylic acid;
   (E) an oxidizing agent; and
   (F) water,

   the abrasives (A) being selected from the group consisting of silica particles, organic particles, and organic-silica composite particles, being included in the chemical mechanical polishing aqueous dispersion in an amount of 2 to 10 wt%,
   wherein the organic acid (B) is at least one organic acid selected from the group consisting of quinolinecarboxylic acid, quinolinic acid, a divalent organic acid (excluding quinolinic acid), and a hydroxyl acid, and is included in the chemical mechanical polishing aqueous dispersion in an amount of 0.01 to 5 wt%,
   wherein the ammonium or potassium salt of polyacrylic acid (D) is included in the chemical mechanical polishing aqueous dispersion in an amount of 0.001 to 5 wt%.

2. The chemical mechanical polishing aqueous dispersion as defined in claim 1, having a pH of 2.0 to 4.0.

3. The chemical mechanical polishing aqueous dispersion as defined in claim 2, wherein the abrasives (A) have an average particle diameter of 5 to 1000 nm.

4. The chemical mechanical polishing aqueous dispersion as defined in any of claims 1 to 3, wherein the organic acid (B) is at least one organic acid selected from the group consisting of quinolinecarboxylic acid, quinolinic acid, maleic acid, malonic acid, citric acid, and malic acid, and is included in the chemical mechanical polishing aqueous dispersion in an amount of 0.05 to 2 wt%.

5. The chemical mechanical polishing aqueous dispersion as defined in any one of claims 1 to 4, wherein the benzotriazole or benzotriazole derivative (C) is benzotriazole, and is included in the chemical mechanical polishing aqueous dispersion in an amount of 0.01 to 5 wt%.

6. The chemical mechanical polishing aqueous dispersion as defined in any one of claims 1 to 5, wherein the ammonium or potassium salt of polyacrylic acid (D) has an average molecular weight of 1,000 to 100,000.

7. The chemical mechanical polishing aqueous dispersion as defined in any of claims 1 to 6, wherein the ammonium or potassium salt of polyacrylic acid (D) is included in the chemical mechanical polishing aqueous dispersion in an amount of 0.01 to 2 wt%.

8. The chemical mechanical polishing aqueous dispersion as defined in any one of claims 1 to 7, wherein the oxidizing agent (E) is hydrogen peroxide, and is included in the chemical mechanical polishing aqueous dispersion in an amount of 0.01 to 5 wt%.

9. A kit for preparing the chemical mechanical polishing aqueous dispersion as defined in any of claims 1 to 8 by mixing a liquid (I) and a liquid (II), the liquid (I) being an aqueous dispersion including the abrasives (A), the organic acid (B), the benzotriazole or benzotriazole derivative (C), the ammonium or potassium salt of polyacrylic acid (D), and the water (F), the abrasives (A) being contained in the aqueous dispersion in an amount of 2 to 10 wt%, and the liquid (II) including the oxidizing agent (E) and the water (F).

10. A kit for preparing the chemical mechanical polishing aqueous dispersion as defined in any of claims 1 to 8 by mixing a liquid (I) and a liquid (II), the liquid (I) being an aqueous dispersion including the abrasives (A) and the water (F), and the liquid (II) including the organic acid (B) and the water (F).

11. A kit for preparing the chemical mechanical polishing aqueous dispersion as defined in any of claims 1 to 8 by mixing a liquid (I), a liquid (II), and a liquid (III), the liquid (I) being an aqueous dispersion including the abrasives (A) and the water (F), the liquid (II) including the organic acid (B) and the water (F), and the liquid (III) including the oxidizing agent (E) and the water (F).

12. The kit for preparing the chemical mechanical polishing aqueous dispersion as defined in claim 10 or 11, wherein the liquid (I) further includes at least one component selected from the organic acid (B), the benzotriazole or benzotriazole derivative (C), the ammonium or potassium salt of polyacrylic acid (D), and the oxidizing agent (E).

13. The kit for preparing the chemical mechanical polishing aqueous dispersion as defined in any one of claims 10 to 12, wherein the liquid (II) further includes at least one component selected from the abrasives (A), the benzotriazole or benzotriazole derivative (C), the ammonium or potassium salt of polyacrylic acid (D), and the oxidizing agent (E).

14. A chemical mechanical polishing method, comprising:

chemically and mechanically polishing a polishing target using a chemical mechanical polishing aqueous dispersion having, when chemically and mechanically polishing each of a copper film, a barrier metal film, and an insulating film under identical conditions, a ratio "$R_{Cu}/R_{BM}$" of a polishing rate RCu of the copper film to a polishing rate RBM of the barrier metal film of 50 or more and a ratio "$R_{Cu}/R_{In}$" of the polishing rate RCu of the copper film to a polishing rate RIn of the insulating film of 50 or more, and then chemically and mechanically polishing the polishing target using the chemical mechanical polishing aqueous dispersion as defined in any of claims 1 to 8.

**Patentansprüche**

1. Wässrige chemisch-mechanische Polierdispersion zur chemischen und mechanischen Polierung eines Kupferfilms, eines Barrieremetall-Films und eines isolierenden Films gleichzeitig, mit einem pH von 1,0 bis 5,0, die aufweist:

(A) Schleifmittel;
(B) eine organische Säure;
(C) Benzotriazol oder ein Benzotriazol-Derivat;
(D) ein Ammonium- oder Kaliumsalz der Polyacrylsäure;
(E) ein oxidierendes Agens; und
(F) Wasser,

wobei die Schleifmittel (A) aus der Gruppe bestehend aus Siliziumdioxid-Teilchen, organischen Teilchen, und zusammengesetzten organisch-Siliziumdioxid-Teilchen ausgewählt sind, die in der wässrigen chemisch-mechanischen Polierdispersion in einer Menge von 2 bis 10 Gew.-% enthalten sind,
wobei die organische Säure (B) zumindest eine organische Säure ausgewählt aus der Gruppe bestehend aus Chinolincarbonsäure, Chinolinsäure, einer zweiwertigen organischen Säure (ausgenommen Chinolinsäure), und einer Hydroxylsäure ist, und in der wässrigen chemisch-mechanischen Polierdispersion in einer Menge von 0,01 bis 5 Gew.-% enthalten ist,
wobei das Ammonium- oder Kaliumsalz der Polyacrylsäure (D) in der wässrigen chemisch-mechanischen Polierdispersion in einer Menge von 0,001 bis 5 Gew.-% enthalten ist.

2. Wässrige chemisch-mechanische Polierdispersion nach Anspruch 1, mit einem pH von 2,0 bis 4,0.

3. Wässrige chemisch-mechanische Polierdispersion nach Anspruch 2, wobei die Schleifmittel (A) einen durchschnittlichen Teilchendurchmesser von 5 bis 1000 nm haben.

4. Wässrige chemisch-mechanische Polierdispersion nach einem der Ansprüche 1 bis 3, wobei die organische Säure (B) zumindest eine organische Säure ausgewählt aus der Gruppe bestehend aus Chinolincarbonsäure, Chinolinsäure, Maleinsäure, Malonsäure, Zitronensäure, und Äpfelsäure ist, und in der wässrigen chemisch-mechanischen Polierdispersion in einer Menge von 0,05 bis 2 Gew.-% enthalten ist.

5. Wässrige chemisch-mechanische Polierdispersion nach einem der Ansprüche 1 bis 4, wobei das Benzotriazol oder Benzotriazol-Derivat (C) Benzotriazol ist, und in der wässrigen chemisch-mechanischen Polierdispersion in einer Menge von 0,01 bis 5 Gew.-% enthalten ist.

**6.** Wässrige chemisch-mechanische Polierdispersion nach einem der Ansprüche 1 bis 5, wobei das Ammonium- oder Kaliumsalz der Polyacrylsäure (D) ein durchschnittliches Molekulargewicht von 1.000 bis 100.000 hat.

**7.** Wässrige chemisch-mechanische Polierdispersion nach einem der Ansprüche 1 bis 6, wobei das Ammonium- oder Kaliumsalz der Polyacrylsäure (D) in der wässrigen chemisch-mechanischen Polierdispersion in einer Menge von 0,01 bis 2 Gew.-% enthalten ist.

**8.** Wässrige chemisch-mechanische Polierdispersion nach einem der Ansprüche 1 bis 7, wobei das oxidierende Agens (E) Wasserstoffperoxid ist, und in der wässrigen chemisch-mechanischen Polierdispersion in einer Menge von 0,01 bis 5 Gew.-% enthalten ist.

**9.** Bausatz zur Anfertigung der wässrigen chemisch-mechanischen Polierdispersion nach einem der Ansprüche 1 bis 8 durch Mischen einer Flüssigkeit (I) und einer Flüssigkeit (II), wobei die Flüssigkeit (I) eine wässrige Dispersion ist, welche die Schleifmittel (A), die organische Säure (B), das Benzotriazol oder Benzotriazol-Derivat (C), das Ammonium- oder Kaliumsalz der Polyacrylsäure (D), und das Wasser (F) enthalten, wobei die Schleifmittel (A) in der wässrigen chemisch-mechanischen Polierdispersion in einer Menge von 2 bis 10 Gew.-% enthalten sind, und die Flüssigkeit (II) das oxidierende Agens (E) und das Wasser (F) enthält.

**10.** Bausatz zur Anfertigung der wässrigen chemisch-mechanischen Polierdispersion nach einem der Ansprüche 1 bis 8 durch Mischen einer Flüssigkeit (I) und einer Flüssigkeit (II), wobei die Flüssigkeit (I) eine wässrige Dispersion ist, welche die Schleifmittel (A) und das Wasser (F) enthält, und die Flüssigkeit (II) die organische Säure (B) und das Wasser (F) enthält.

**11.** Bausatz zur Anfertigung der wässrigen chemisch-mechanischen Polierdispersion nach einem der Ansprüche 1 bis 8 durch Mischen einer Flüssigkeit (I), einer Flüssigkeit (II), und einer Flüssigkeit (III), wobei die Flüssigkeit (I) eine wässrige Dispersion ist, welche die Schleifmittel (A) und das Wasser (F) enthält, die Flüssigkeit (II) die organische Säure (B) und das Wasser (F) enthält, und die Flüssigkeit (III) das oxidierende Agens (E) und das Wasser (F) enthält.

**12.** Bausatz zur Anfertigung der wässrigen chemisch-mechanischen Polierdispersion nach einem der Ansprüche 10 oder 11, wobei die Flüssigkeit (I) ferner zumindest eine Komponente ausgewählt aus der organischen Säure (B), dem Benzotriazol oder Benzotriazol-Derivat (C), dem Ammonium- oder Kaliumsalz der Polyacrylsäure (D), und dem oxidierenden Agens (E) enthält.

**13.** Bausatz zur Anfertigung der wässrigen chemisch-mechanischen Polierdispersion nach einem der Ansprüche 10 bis 12, wobei die Flüssigkeit (II) ferner zumindest eine Komponente ausgewählt aus den Schleifmitteln (A), dem Benzotriazol oder Benzotriazol-Derivat (C), dem Ammonium- oder Kaliumsalz der Polyacrylsäure (D), und dem oxidierenden Agens (E) enthält.

**14.** Chemisch-mechanisches Polierverfahren, welches enthält:

chemisches und mechanisches Polieren eines zu polierenden Materials unter Verwendung einer wässrigen chemisch-mechanischen Polierdispersion, das, wenn jeweils ein Kupferfilm, ein Barrieremetall-Film, und ein isolierender Film unter identischen Bedingungen chemisch und mechanisch poliert werden, ein Verhältnis "RCu/RBM" einer Polierrate RCu des Kupferfilms zu einer Polierrate RBM des Barrieremetall-Films von 50 oder mehr und ein Verhältnis "RCu/RIn" der Polierrate RCu des Kupferfilms zu einer Polierrate RIn des isolierenden Films von 50 oder mehr hat, und dann chemisches und mechanisches Polieren des zu polierenden Materials unter Verwendung der wässrigen chemisch-mechanischen Polierdispersion nach einem der Ansprüche 1 bis 8.

## Revendications

**1.** Dispersion aqueuse de polissage chimico-mécanique pour polir, à la fois chimiquement et mécaniquement, un film de cuivre, un film métallique barrière, et un film isolant, ayant un pH de 1,0 à 5,0, comprenant :

(A) des abrasifs;

(B) un acide organique;
(C) du benzotriazole ou un dérivé du benzotriazole;
(D) un sel d'ammonium ou de potassium d'un acide polyacrylique;
(E) un agent oxydant; et
(F) de l'eau,

les abrasifs (A) étant sélectionnés parmi le groupe constitué de particules de silice, de particules organiques, et de particules composites de silice organique, sont inclus dans la dispersion aqueuse de polissage chimico-mécanique en une quantité de 2 à 10 % en poids,
où l'acide organique (B) est au moins un acide organique sélectionné parmi le groupe constitué d'un acide quinolinecarboxylique, un acide quinolinique, un acide organique divalent (à l'exception de l'acide quinolinique), et un acide hydroxylique, et est inclus dans la dispersion aqueuse de polissage chimico-mécanique en une quantité de 0,01 à 5 % en poids,
où le sel d'ammonium ou de potassium d'acide polyacrylique (D) est inclus dans la dispersion aqueuse de polissage chimico-mécanique en une quantité de 0,001 à 5 % en poids.

2. Dispersion aqueuse de polissage chimico-mécanique telle que définie dans la revendication 1, ayant un pH de 2,0 à 4,0.

3. Dispersion aqueuse de polissage chimico-mécanique telle que définie dans la revendication 2, où les abrasifs (A) ont un diamètre de particules moyen de 5 à 1000 nm.

4. Dispersion aqueuse de polissage chimico-mécanique telle que définie dans l'une quelconque des revendications 1 à 3,
où l'acide organique (B) est au moins un acide organique sélectionné parmi le groupe constitué d'un acide quinolinecarboxylique, un acide quinolinique, un acide maléique, un acide malonique, un acide citrique, et un acide malique, et est inclus dans la dispersion aqueuse de polissage chimico-mécanique en une quantité de 0,05 à 2 % en poids.

5. Dispersion aqueuse de polissage chimico-mécanique telle que définie dans l'une quelconque des revendications 1 à 4,
où le benzotriazole ou un dérivé du benzotriazole (C) est du benzotriazole, et est inclus dans la dispersion aqueuse de polissage chimico-mécanique en une quantité de 0,01 à 5 % en poids.

6. Dispersion aqueuse de polissage chimico-mécanique telle que définie dans l'une quelconque des revendications 1 à 5,
où le sel d'ammonium ou de potassium d'un acide polyacrylique (D) à un poids moléculaire moyen de 1000 à 100000.

7. Dispersion aqueuse de polissage chimico-mécanique telle que définie dans l'une quelconque des revendications 1 à 6,
où le sel d'ammonium ou de potassium d'un acide polyacrylique (D) est inclus dans la dispersion aqueuse de polissage chimico-mécanique en une quantité de 0,01 à 2 % en poids.

8. Dispersion aqueuse de polissage chimico-mécanique telle que définie dans l'une quelconque des revendications 1 à 7,
où l'agent oxydant (E) est du peroxyde d'hydrogène, et est inclus dans la dispersion aqueuse de polissage chimico-mécanique en une quantité de 0,01 à 5 % en poids.

9. Kit pour préparer la dispersion aqueuse de polissage chimico-mécanique telle que définie dans l'une quelconque des revendications 1 à 8 en mélangeant un liquide (I) et un liquide (II), le liquide (I) étant une dispersion aqueuse incluant les abrasifs (A), l'acide organique (B), le benzotriazole ou un dérivé du benzotriazole (C); le sel d'ammonium ou de potassium d'un acide polyacrylique (D); et l'eau (F), les abrasifs (A) étant contenus dans la dispersion aqueuse en une quantité de 2 à 10 % en poids, et le liquide (II) incluant l'agent oxydant (E) et l'eau (F).

10. Kit pour préparer la dispersion aqueuse de polissage chimico-mécanique telle que définie dans l'une quelconque des revendications 1 à 8 en mélangeant un liquide (I) et un liquide (II), le liquide (I) étant une dispersion aqueuse incluant les abrasifs (A) et l'eau (F), et le liquide (II) incluant l'acide organique (B) et l'eau (F).

**11.** Kit pour préparer la dispersion aqueuse de polissage chimico-mécanique telle que définie dans l'une quelconque des revendications 1 à 8 en mélangeant un liquide (I), un liquide (II), et un liquide (III), le liquide (I) étant une dispersion aqueuse incluant les abrasifs (A) et l'eau (F), le liquide (II) incluant l'acide organique (B) et l'eau (F), et le liquide (III) incluant l'agent oxydant (E) et l'eau (F).

**12.** Kit pour préparer la dispersion aqueuse de polissage chimico-mécanique telle que définie dans la revendication 10 ou 11,
où le liquide (I) comporte en plus au moins un composant sélectionné parmi l'acide organique (B), le benzotriazole ou un dérivé de benzotriazole (C), le sel d'ammonium ou de potassium d'un acide polyacrylique (D), et l'agent oxydant (E).

**13.** Kit pour préparer la dispersion aqueuse de polissage chimico-mécanique telle que définie dans l'une quelconque des revendications 10 à 12,
où le liquide (II) comporte en outre au moins un composant sélectionné parmi les abrasifs (A), le benzotriazole ou un dérivé du benzotriazole (C), le sel d'ammonium ou de potassium d'un acide polyacrylique (D), et l'agent oxydant (E).

**14.** Procédé de polissage chimico-mécanique, comprenant:

polir chimiquement et mécaniquement une cible de polissage en utilisant une dispersion aqueuse de polissage chimico-mécanique ayant, lors du polissage chimique et mécanique de chacun d'un film de cuivre, d'un film métallique barrière, et d'un film isolant dans des conditions identiques, un rapport "RCu/RBM" d'un taux de polissage RCu du film de cuivre par un taux de polissage RBM du film métallique barrière de 50 ou plus et un rapport "RCu/RIn" du taux de polissage RCu du film de cuivre par un taux de polissage RIn du film isolant de 50 ou plus, et polir ensuite chimiquement et mécaniquement la cible de polissage en utilisant la dispersion aqueuse de polissage chimico-mécanique telle que définie dans l'une quelconque des revendications 1 à 8.

**FIG. 1A**

**FIG. 1B**

**FIG. 1C**

**FIG. 2A**

**FIG. 2B**

**FIG. 2C**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001196336 A